# EUROPEAN PATENT APPLICATION

(11) **EP 4 845 376 A1**
(43) Date of publication of application: **25.11.2026**
(21) Application number: 26163174.1
(22) Date of filing: 09.03.2026
(51) Int. Cl.: H10W 40/20, H10W 40/00, H10W 40/22, H10W 40/60, H10W 90/00, H10W 90/10

(54) **ELECTRONIC DEVICE AND CHIP CARRIER HEAT SINK**

(30) Priority: 20.05.2025 TW 114118764
(71) Applicant: Giga-Byte Technology Co., Ltd., New Taipei City 231 (TW)
(72) Inventor: LIAO, Tse-Hsien, 231 New Taipei City (TW); HUANG, Ching-Hsun, 231 New Taipei City (TW); SHIH, Po-Jen, 231 New Taipei City (TW); CHIANG, Fang-Hsuan, 231 New Taipei City (TW); YEN, An-Ru, 231 New Taipei City (TW); HUANG, Guan-Zheng, 231 New Taipei City (TW)
(74) Representative: Becker, Eberhard

(57) **Abstract**

An electronic device (100) includes a chip carrier (110), a chip (120), an integrated heat sink (IHS) (130), and a chip carrier heat sink (140). The chip (120) is disposed on the chip carrier (110). The integrated heat sink (130) is disposed on the chip carrier (110), covering and thermally coupled to the chip (120). The chip carrier heat sink (140) is disposed at a periphery of the integrated heat sink (130) and includes a main body (141). The main body (141) includes an opening (144) exposing the integrated heat sink (130). The chip carrier heat sink (140) is joined to and thermally coupled to the chip carrier (110). A portion of heat generated by the chip (120) is dissipated through the integrated heat sink (130), and another portion of heat generated by the chip (120) is transferred to the chip carrier heat sink (140) through the chip carrier (110).

## Description

### BACKGROUND

### Technical Field

The disclosure relates to an electronic device and a heat sink, and in particular to an electronic device and a chip carrier heat sink capable of improving the heat dissipation performance of a chip.

### Description of Related Art

Generally, the heat generated by a chip can only be dissipated from an integrated heat sink (IHS) disposed on the upper side to a heat dissipation structure thermally coupled to the integrated heat sink. However, since the integrated heat sink has fixed dimensions, the heat transfer area of the integrated heat sink is constrained by its dimensions, thereby limiting the heat dissipation performance of the chip.

### SUMMARY

The disclosure provides a chip carrier heat sink, which may improve the heat dissipation performance of a chip.

The disclosure provides an electronic device having the chip carrier heat sink.

An electronic device of the disclosure includes a chip carrier, a chip, an integrated heat sink (IHS), and a chip carrier heat sink. The chip is disposed on the chip carrier. The integrated heat sink is disposed on the chip carrier, covering and thermally coupled to the chip. The chip carrier heat sink is disposed at a periphery of the integrated heat sink and includes a main body. The main body includes an opening for exposing the integrated heat sink. The chip carrier heat sink is joined to and thermally coupled to the chip carrier. A portion of heat generated by the chip is dissipated through the integrated heat sink, and another portion of heat generated by the chip is transferred to the chip carrier heat sink through the chip carrier.

In an embodiment of the disclosure, the chip carrier heat sink is separated from the integrated heat sink.

In an embodiment of the disclosure, the main body includes a top plate and a plurality of walls protruding from the top plate, the top plate and the walls together form a bottom cavity, the top plate includes the opening, the opening communicates with the bottom cavity, and the chip carrier and the chip are located in the bottom cavity.

In an embodiment of the disclosure, a first top surface of the integrated heat sink is coplanar with a second top surface of the top plate.

In an embodiment of the disclosure, the chip carrier heat sink includes at least one fin portion extending from the main body.

In an embodiment of the disclosure, the chip carrier heat sink further includes a first heat conducting member located between the top plate of the main body and the chip carrier.

In an embodiment of the disclosure, the electronic device further includes a circuit board, in which the chip carrier is disposed on the circuit board, and the walls of the main body are thermally coupled to the circuit board.

In an embodiment of the disclosure, the chip carrier heat sink further includes a second heat conducting member located between the walls of the main body and the circuit board.

In an embodiment of the disclosure, the integrated heat sink includes a plurality of inner recess portions recessed from an edge, the chip carrier heat sink includes a plurality of outer convex portions extending toward the opening, and the outer convex portions correspond to the inner recess portions.

A chip carrier heat sink of the disclosure for a chip carrier, in which a chip and an integrated heat sink are disposed on the chip carrier. The integrated heat sink covers and is thermally coupled to the chip. The chip carrier heat sink includes a main body including an opening. When the chip carrier heat sink is disposed on the chip carrier, the chip carrier heat sink is located at a periphery of the integrated heat sink. The opening exposes the integrated heat sink. The chip carrier heat sink is joined to and thermally coupled to the chip carrier. A portion of heat generated by the chip is adapted to be dissipated through the integrated heat sink, and another portion of heat generated by the chip is adapted to be transferred to the chip carrier heat sink through the chip carrier.

**In** an embodiment of the disclosure, the main body includes a top plate and a plurality of walls protruding from the top plate, the top plate and the walls together form a bottom cavity, the top plate includes the opening, and the opening communicates with the bottom cavity.

**In** an embodiment of the disclosure, the chip carrier heat sink further includes a first heat conducting member located between the top plate of the main body and the chip carrier.

**In** an embodiment of the disclosure, the chip carrier heat sink further includes a second heat conducting member located between the walls of the main body and the circuit board.

**In** an embodiment of the disclosure, the chip carrier heat sink further includes at least one fin portion extending from the main body.

**In** view of the above, the integrated heat sink of the electronic device of the disclosure is disposed on the chip carrier, covering and thermally coupled to the chip. The chip carrier heat sink is disposed at a periphery of the integrated heat sink, and the opening of the main body of the chip carrier heat sink exposes the integrated heat sink. The chip carrier heat sink is joined to and thermally coupled to the chip carrier. A portion of heat generated by the chip is dissipated through the integrated heat sink, and another portion of heat generated by the chip is transferred to the chip carrier heat sink through the chip carrier. Therefore, the chip of the electronic device of the disclosure may dissipate heat through two heat dissipation paths, and the heat dissipation performance of the chip may be effectively enhanced.

### BRIEF DESCRIPTION OF THE DRAWINGS

FIG. 1 is a perspective schematic view of an electronic device according to an embodiment of the disclosure.
FIG. 2 is a perspective schematic view of the integrated heat sink and the chip carrier heat sink of FIG. 1.
FIG. 3 and FIG. 4 are perspective schematic views of the chip carrier heat sink of FIG. 1 from a different perspective.
FIG. 5 is a schematic view of the chip carrier heat sink of FIG. 4 with a first heat conducting member and a second heat conducting member disposed on the lower surface.
FIG. 6 is a partial cross-sectional schematic view of FIG. 1.

### DESCRIPTION OF THE EMBODIMENTS

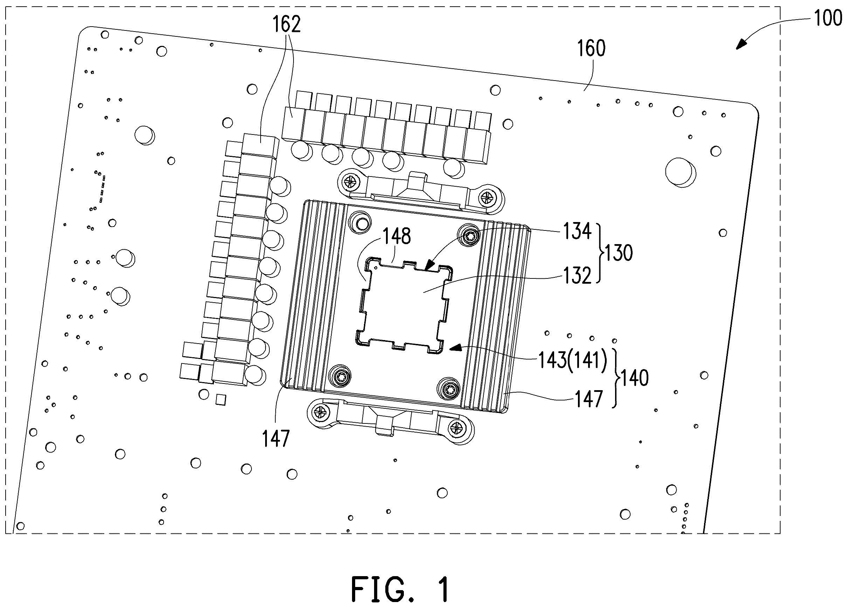

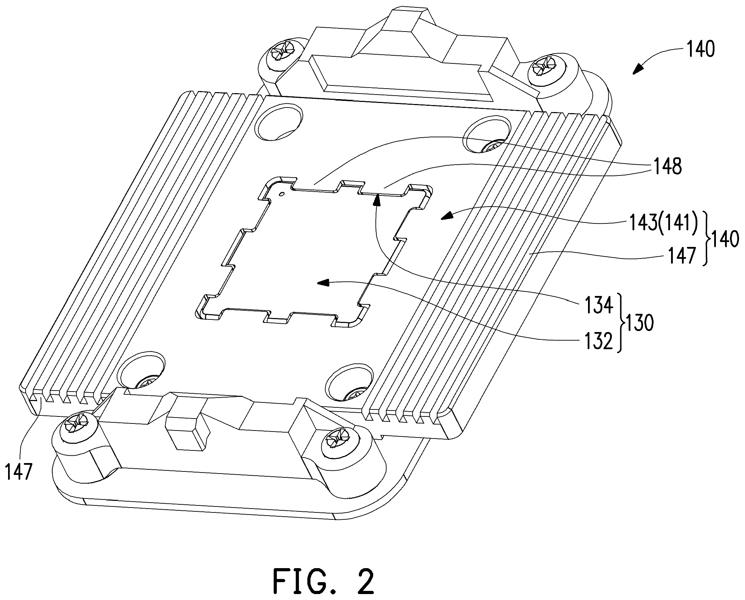

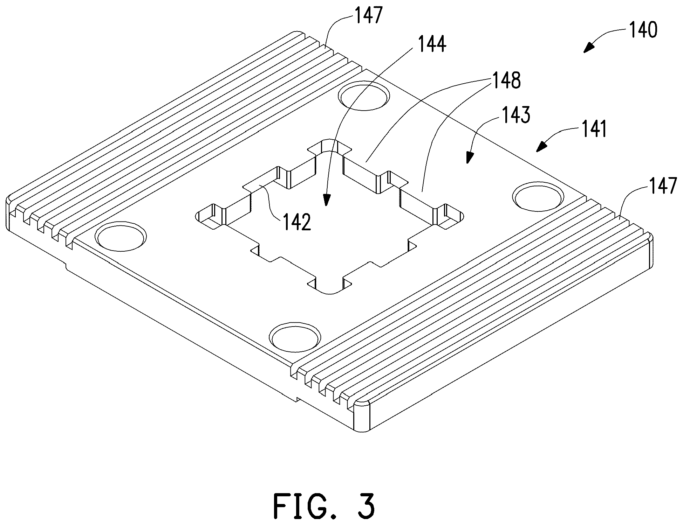

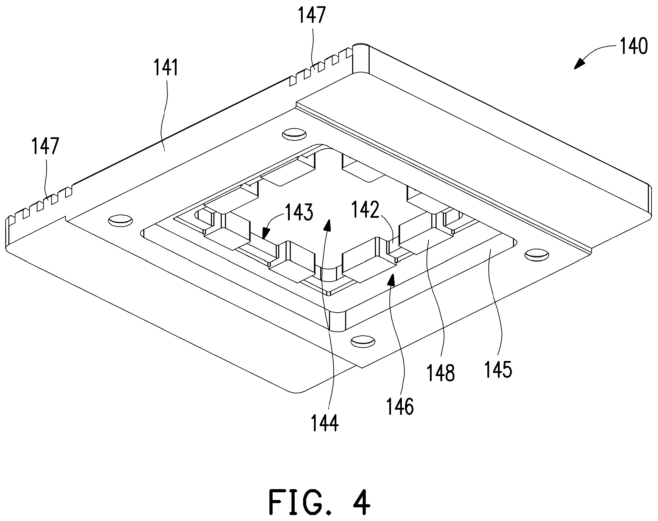

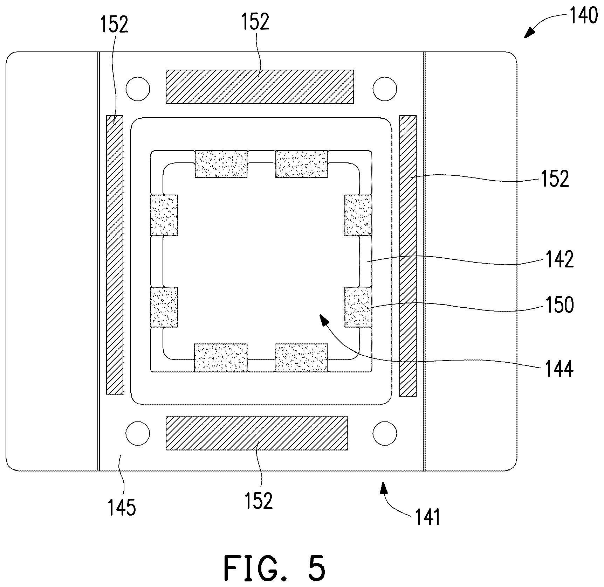

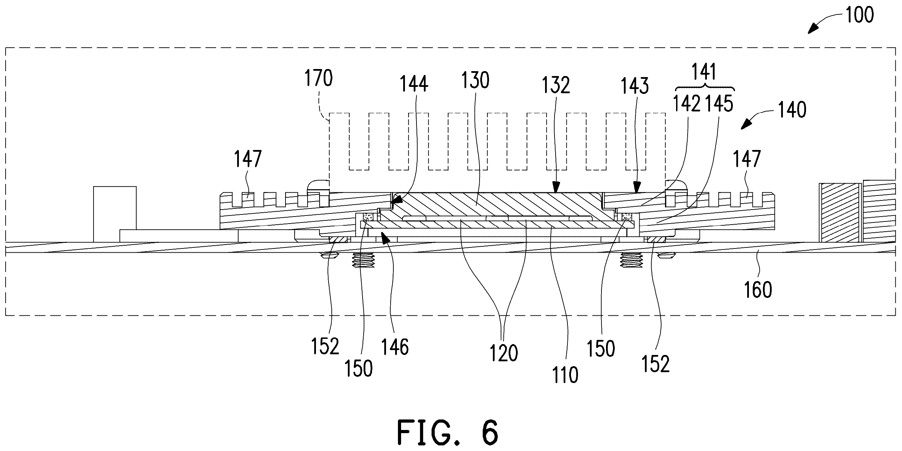

FIG. 1 is a perspective schematic view of an electronic device according to an embodiment of the disclosure. FIG. 2 is a perspective schematic view of the integrated heat sink and the chip carrier heat sink of FIG. 1. FIG. 3 and FIG. 4 are perspective schematic views of the chip carrier heat sink of FIG. 1 from a different perspective. FIG. 5 is a schematic view of the chip carrier heat sink of FIG. 4 with a first heat conducting member and a second heat conducting member disposed on the lower surface. FIG. 6 is a partial cross-sectional schematic view of FIG. 1.

Referring to FIG. 1 to FIG. 6, an electronic device 100 of the embodiment may be, for example, a motherboard module or a graphics card module, but the type of the electronic device 100 is not limited thereto. The electronic device 100 of the embodiment includes a chip carrier 110 (FIG. 6), a chip 120 (FIG. 6), an integrated heat sink (IHS) 130, and a chip carrier heat sink 140.

As shown in FIG. 6, the electronic device 100 further includes a circuit board 160. The chip carrier 110 is disposed on the circuit board 160, and the chip 120 is disposed on the chip carrier 110. The chip 120 may be, for example, a central processing unit (CPU), but the type of the chip 120 is not limited thereto. The integrated heat sink 130 is disposed on the chip carrier 110, covering and thermally coupled to the chip 120.

The chip carrier heat sink 140 is disposed at a periphery of the integrated heat sink 130. As shown in FIG. 2, in the embodiment, the integrated heat sink 130 includes a plurality of inner recess portions 134 recessed from an edge, the chip carrier heat sink 140 includes a plurality of outer convex portions 148 extending toward the opening 144. The outer convex portions 148 correspond to the inner recess portions 134, enabling the chip carrier heat sink 140 to be embedded at the periphery of the integrated heat sink 130 through the design of concave-convex fitting.

Of course, in other embodiments, the shapes of the chip carrier heat sink 140 and the integrated heat sink 130 are not limited thereto. In addition, the chip carrier heat sink 140 includes high-heat-conductive materials, such as metals like copper, aluminum, and iron, but not limited thereto.

The chip carrier heat sink 140 includes a main body 141. The main body 141 includes an opening 144 for exposing the integrated heat sink 130. The chip carrier heat sink 140 is joined to and thermally coupled to the chip carrier 110. Specifically, as shown in FIG. 6, in the embodiment, the main body 141 includes a top plate 142 and a plurality of walls 145 protruding from the top plate 142. The top plate 142 and the walls 145 together form a bottom cavity 146. The top plate 142 includes the opening 144. The opening 144 communicates with the bottom cavity 146. The chip carrier 110 and the chip 120 are located in the bottom cavity 146.

In the embodiment, the chip carrier heat sink 140 further includes a first heat conducting member 150, located between the top plate 142 of the main body 141 and the chip carrier 110. The first heat conducting member 150 may include, for example, thermal paste or thermal adhesive strip, but not limited thereto. The heat generated by the chip 120 may be transferred to the chip carrier heat sink 140 through the chip carrier 110 and the first heat conducting member 150.

Therefore, a portion of the heat generated by the chip 120 is dissipated through the integrated heat sink 130, and another portion of the heat generated by the chip 120 is transferred to the chip carrier heat sink 140 through the chip carrier 110. The heat of the chip 120 may be dissipated through the integrated heat sink 130 and the chip carrier heat sink 140 simultaneously, enabling faster reduction of the temperature of the chip 120, thereby enhancing the overall heat dissipation efficiency.

In addition, as shown in FIG. 6, a first top surface 132 of the integrated heat sink 130 is coplanar with a second top surface 143 of the top plate 142. In the embodiment, the electronic device 100 further includes a heat dissipation structure 170, disposed on the first top surface 132 of the integrated heat sink 130 and the second top surface 143 of the top plate 142, so as to be thermally coupled to the integrated heat sink 130 and the chip carrier heat sink 140. The heat dissipation structure 170 may include a combination of fins, fan or/and water cooling head, etc., for dissipating heat from the integrated heat sink 130 and the chip carrier heat sink 140.

It is worth mentioning that, as shown in FIG. 6, in the embodiment, the chip carrier heat sink 140 is separated from the integrated heat sink 130. There is a gap between the chip carrier heat sink 140 and the integrated heat sink 130 to prevent direct contact. As such, the heat of the integrated heat sink 130 and the chip carrier heat sink 140 may be directly conducted to the heat dissipation structure 170 above, rather being directly conducted therebetween.

That is to say, the chip carrier heat sink 140 is not a mere enlargement of the integrated heat sink 130; rather, the chip carrier heat sink 140 adds another heat dissipation path different from the integrated heat sink 130 to enhance the overall heat dissipation performance. In the embodiment, compared to the integrated heat sink 130 which is in direct contact with the chip 120, the chip carrier heat sink 140 is mainly for dissipating heat conducted from the chip 120 to the chip carrier 110.

In addition, in the embodiment, the chip carrier heat sink 140 includes at least one fin portion 147 extending from the main body 141. The at least one fin portion 147 may be, for example, two fin portions 147, located on two opposite sides of the main body 141. Thermal energy may be conducted from the main body 141 of the chip carrier heat sink 140 to the two fin portions 147, and dissipated through the large-area fin portions 147.

In addition, as shown in FIG. 6, the walls 145 of the main body 141 of the chip carrier heat sink 140 are thermally coupled to the circuit board 160, and may dissipate heat from the circuit board 160. Specifically, the chip carrier heat sink 140 further includes a second heat conducting member 152, located between the walls 145 of the main body 141 and the circuit board 160. The heat of the circuit board 160 may be conducted to the chip carrier heat sink 140 through the second heat conducting member 152. The second heat conducting member 152 may include, for example, thermal paste or thermal adhesive strip, but not limited thereto.

Further, referring back to FIG. 1, in the embodiment, the circuit board 160 further includes two rows of power conversion elements 162 located on two sides of the chip carrier heat sink 140. The power conversion elements 162 are connected to the chip 120 through wiring within the circuit board 160. Since the chip carrier heat sink 140 is thermally coupled to the circuit board 160 through the second heat conducting member 152, the chip carrier heat sink 140 may also dissipate heat from the wiring on the circuit board 160 connected between the power conversion elements 162 and the chip 120, thereby enhancing the overall heat dissipation performance of the electronic device 100. Of course, the chip carrier heat sink 140 may also dissipate heat from other wiring on the circuit board 160, and is not limited thereto.

In summary, the integrated heat sink of the electronic device of the disclosure is disposed on the chip carrier, covering and thermally coupled to the chip. The chip carrier heat sink is disposed at a periphery of the integrated heat sink, and the opening of the main body of the chip carrier heat sink exposes the integrated heat sink. The chip carrier heat sink is joined to and thermally coupled to the chip carrier. A portion of heat generated by the chip is dissipated through the integrated heat sink, and another portion of heat generated by the chip is transferred to the chip carrier heat sink through the chip carrier. Therefore, the chip of the electronic device of the disclosure may dissipate heat through two heat dissipation paths, and the heat dissipation performance of the chip may be effectively enhanced.

## Claims

1. An electronic device (100), comprising:
a chip carrier (110);
a chip (120), disposed on the chip carrier (110);
an integrated heat sink (IHS) (130), disposed on the chip carrier (110), covering and thermally coupled to the chip (120); and
a chip carrier heat sink (140), disposed at a periphery of the integrated heat sink (130), and comprising a main body (141), wherein the main body (141) comprises an opening (144) for exposing the integrated heat sink (130), and the chip carrier heat sink (140) is joined to and thermally coupled to the chip carrier (110), wherein
a portion of heat generated by the chip (120) is dissipated through the integrated heat sink (130), and another portion of heat generated by the chip (120) is transferred to the chip carrier heat sink (140) through the chip carrier (110).

2. The electronic device (100) according to claim 1, wherein the chip carrier heat sink (140) is separated from the integrated heat sink (130).

3. The electronic device (100) according to claim 1, wherein the main body (141) comprises a top plate (142) and a plurality of walls (145) protruding from the top plate (142), the top plate (142) and the plurality of walls (145) together form a bottom cavity (146), the top plate (142) comprises the opening (144), the opening (144) communicates with the bottom cavity (146), and the chip carrier (110) and the chip (120) are located in the bottom cavity (146).

4. The electronic device (100) according to claim 3, wherein a first top surface (132) of the integrated heat sink (130) is coplanar with a second top surface (143) of the top plate (142).

5. The electronic device (100) according to claim 3, wherein the chip carrier heat sink (140) comprises at least one fin portion (147) extending from the main body (141).

6. The electronic device (100) according to claim 3, wherein the chip carrier heat sink (140) further comprises a first heat conducting member (150), located between the top plate (142) of the main body (141) and the chip carrier (110).

7. The electronic device (100) according to claim 3, further comprising a circuit board (160), wherein the chip carrier (110) is disposed on the circuit board (160), and the plurality of walls (145) of the main body (141) are thermally coupled to the circuit board (160).

8. The electronic device (100) according to claim 7, wherein the chip carrier heat sink (140) further comprises a second heat conducting member (152), located between the plurality of walls (145) of the main body (141) and the circuit board (160).

9. The electronic device (100) according to claim 1, wherein the integrated heat sink (130) comprises a plurality of inner recess portions (134) recessed from an edge, the chip carrier heat sink (140) comprises a plurality of outer convex portions (148) extending toward the opening (144), and the plurality of outer convex portions (148) correspond to the plurality of inner recess portions (134).

10. A chip carrier heat sink (140) for a chip carrier (110), wherein a chip (120) and an integrated heat sink (130) are disposed on the chip carrier (110), the integrated heat sink (130) covers and is thermally coupled to the chip (120), and the chip carrier heat sink (140) comprises: a main body (141), comprising an opening (144), wherein when the chip carrier heat sink (140) is disposed on the chip carrier (110), the chip carrier heat sink (140) is located at a periphery of the integrated heat sink (130), the opening (144) exposes the integrated heat sink (130), the chip carrier heat sink (140) is joined to and thermally coupled to the chip carrier (110), a portion of heat generated by the chip (120) is adapted to be dissipated through the integrated heat sink (130), and another portion of heat generated by the chip (120) is adapted to be transferred to the chip carrier heat sink (140) through the chip carrier (110).

11. The chip carrier heat sink (140) according to claim 10, wherein the main body (141) comprises a top plate (142) and a plurality of walls (145) protruding from the top plate (142), the top plate (142) and the plurality of walls (145) together form a bottom cavity (146), the top plate (142) comprises the opening (144), and the opening (144) communicates with the bottom cavity (146).

12. The chip carrier heat sink (140) according to claim 11, further comprising a first heat conducting member (150), located between the top plate (142) of the main body (141) and the chip carrier (110).

13. The chip carrier heat sink (140) according to claim 10, further comprising at least one fin portion (147) extending from the main body (141).
